# EUROPEAN PATENT SPECIFICATION

(11) **EP 3 644 381 B1**
(45) Date of publication and mention of the grant of the patent: **05.05.2021**
(21) Application number: 18382760.9
(22) Date of filing: 26.10.2018
(51) Int. Cl.: H01L 39/14, H01L 39/24

(54) **SUPERCONDUCTOR MATERIAL AND PROCESS FOR PRODUCING THE SAME**
SUPRALEITERMATERIAL UND VERFAHREN ZU DESSEN HERSTELLUNG
MATÉRIAU DE SUPRACONDUCTEUR ET SON PROCÉDÉ DE PRODUCTION

(43) Date of publication of application: 29.04.2020
(73) Proprietor: Oxolutia, S.L., 08210 Barberà del Vallès (ES); Consejo Superior De Investigaciones Científicas, 28006 Madrid (ES); Lacroix, Christian, Montréal, Québec H2S 2P9 (CA); Sirois, Frédéric, Montreal H1M 2E7 (CA)
(72) Inventor: Lacroix, Christian, Montréal H2S 2P9 (CA); Sirois, Frédéric, Montreal H1M 2E7 (CA); Calleja Lazaro, Alberto, 08210 Barberà del Vallès (ES); Vlad, Valentina Roxana, 08210 Barberà del Vallès (ES); Palmer Paricio, Javier, 08210 Barberà del Vallès (ES); Obradors Berenguer, Francesc Xavier, 08193 Bellaterra (ES); Granados García, Xavier, 08193 Bellaterra (ES); Puig Molina, María Teresa, 08193 Bellaterra (ES); Barusco, Pedro, 08193 Bellaterra (IT)
(74) Representative: Clarke Modet & Co.

(56) References cited:
- WO-A1-2005/011008
- WO-A1-2013/113125
- WO-A2-2008/079443
- US-A1- 2006 040 829
- US-A1- 2009 233 800

## Description

### Field of the invention

The present invention refers to the field of superconductors, more precisely to second-generation superconductors comprising a current flow diverter layer and to processes for large-scale production of said type of superconductor materials.

### Background of the invention

Superconductors are materials that conduct electricity without resistance (superconductive state), when i) they are cooled below a temperature called the critical temperature (T_{c}), ii) a magnetic field applied to the superconductor is less than the critical field (B_{c}), and iii) the current density in the superconductor is less than the critical current density (J_{c}). Superconductors are used in applications such as motors, generators, transformers, particle accelerators, nuclear magnetic resonance (hereinafter, NMR), magnetic resonance imaging (hereinafter, MRI), magnetic separation, superconducting magnetic storage systems (hereinafter, SMES) and fault current limiters (hereinafter, FCLs). The advantages of using superconductors over conventional conductors, such as copper or aluminium, are energy efficiency, weight reduction, compactness, production of higher magnetic fields, increased protection level and reliability of supply in power systems (FCLs). In all these applications, the superconductor material should be protected from the quench. Quench is the transition from the superconducting to the normal state when the critical current is exceeded causing heat generation. If the power during quench is not properly dissipated, catastrophic destruction of the material can occur. In fact, some applications, such as resistive superconducting FCLs, which aim to protect electrical equipment in the electrical grid, are based on the "quench" of the superconductor. If a fault occurs in the grid, the line current increases to several times the nominal value and the current density in the superconductor exceeds J_{c}. The superconductor then becomes resistive and the energy dissipation raises its temperature, T. When T reaches T_{c}, the superconductor becomes normal (normal state) and its resistivity becomes very high, even compared with that of normal metals like copper (Cu) or silver (Ag). To the electrical network, this is seen as a sudden insertion of high impedance in series with the source, which reduces the line current and enables the device to protect expensive electrical equipment downstream.

Second-generation superconductor materials were generated, which consisted of a metal substrate, with deposited oxide layers (buffer layers), on which the superconductor was grown (typically REBa₂Cu₃O₇₋ₓ (wherein x is between 0 and 1), where RE is a rare-earth such as Y, Gd, Er, Sm, Nd, Dy, Eu or Ho, among others). All this, surrounded by a metal coating (stabilizer layer, typically Ag or Cu), which acted as a stabilizer by i) providing an alternative current path when the superconductor becomes normal, and ii) acting as a heat sink. These materials possess excellent properties (high critical current density with or without magnetic field, and high mechanical strength). When a quench occurs in these second-generation materials, the current transits to the stabilizer layer. Unfortunately, when the applied current per unit of superconductor width is near I_{c}=J_{c}×d (wherein d is the thickness of the superconductor layer and I_{c} is critical intensity per unit of width), so-called hot spots (rapid increases of local temperature at small regions of the superconductor material) can appear and eventually can destroy the superconductor. The appearance of hot spots is the result of a combination of factors. First, there is a variation of J_{c} along the segment, between 10 to 20% around the mean value. This variation of J_{c} is unavoidable in the current fabrication processes. As a consequence, when the applied current density in the superconductor is close to J_{c}, the quench is nonuniform, meaning that the weakest zones of the superconductor layer become normal while the rest of the segment remains superconducting. In this case, the current transits to the stabilizer layer only where the superconductor layer is normal, since the current follows the path of least resistance. The segment becomes fully quenched when the initial normal zone expands to the entire length of the superconductor layer (the superconductor is then said to be "fully quenched"). The growth rate of the normal zone, what is called the normal zone propagation velocity, is very low due to the low thermal conductivity of the superconductors. As a result, the temperature of the initial normal zone can increase drastically before the segment becomes fully quenched, which can destroy the segment and render it unusable. This local region in the superconductor where the temperature increases drastically is called a hot spot. From an application point of view, it is critical to avoid the appearance of hot spots, to prevent the deterioration of the device.

In the state of the art, several solutions were proposed to solve the above-mentioned problem, for example, increasing the thickness of the stabilizer layer to avoid destroying the segment when a hot spot nucleates, but with the accompanying drawbacks of an increased production cost, and a loss of fault current limitation capability.

On the other side, United States Patent US9029296B2 proposed to solve the above-mentioned problem by introducing a current flow diverter layer which would increase the normal zone propagation velocity by increasing the resistance between the superconductor layer and the stabilizer layer. Therefore, US9029296B2 discloses a superconductor material comprising:
a substrate;
a superconductor layer deposited on the substrate;
a stabilizer layer having an electrical resistance greater than the superconductor layer when said layer is in a superconducting state and lower than the superconductor layer when said layer is in a normal state, and comprising an inner surface at least partly in contact with the superconductor layer and an opposed outer surface; and
a current flow diverter layer having a greater electrical resistance than the stabilizer layer, and located between the stabilizer layer and the superconductor layer or inside the stabilizer layer, the current flow diverter layer extending between the superconductor layer and the stabilizer layer's outer surface along a portion of the superconductor layer.

However, US9029296B2 only discloses small scale or laboratory scale production processes which are not suitable for large-scale cost-effective production of said superconductor material.

Therefore, there is still the need in the state of the art for the development of a process which allows a large-scale and cost-effective production of second-generation superconductor materials comprising a current flow diverter layer.

Superconductor laminates with the structure as discussed in the present application are known from WO 2013/113125 A1 and WO 2008/079443 A1. Also, depositing layers of a superconducting laminate (in particular precursor layers for the superconducting oxide) by ink jet printing is principally known from US2006/0040829 A1 and US2009/0233800 A1.

The inventors of the present invention, after extensive and exhaustive research, have surprisingly found that it is possible to solve the problems present in the state by means of using, for the production of the second-generation superconductor materials comprising a current flow diverter layer, a method of inkjet-printing with the appropriate printing pattern being applied (appropriate pattern of activation and deactivation of printing nozzles used in the inkjet-printing of the current flow diverter ink). The inventors have observed that when using inkjet-printing to prepare or obtain the current flow diverter layer but without the printing pattern of the present invention, meniscus of a thickness at least 5 times higher than the thickness of the current flow diverter layer appears in the two lateral edges of said layer (for example, when the current flow diverter layer has a thickness of 100 nm, then, the above-mentioned meniscus in the two lateral edges thereof have a thickness of 500 nm or higher). Said meniscus do not allow an appropriate oxygenation of the superconductor layer and alter the superconductive properties of said layer, therefore, providing an unacceptable superconductor material. By using the printing pattern of the present invention these problems are solved while allowing to provide a large-scale and cost-effective process for the production of a second-generation superconductor material comprising a current flow diverter layer.

Moreover, the inventors of the present patent application have also discovered an oxygenation procedure which provides for an effective oxygenation of the superconductor layer in second-generation superconductor materials comprising a current flow diverter layer and, hence, allows to obtain materials with appropriate superconducting properties.

In addition, the process of the present invention also provides for a correct deposition of an electrically insulating oxide (for example, in the form of a current flow diverter layer) onto a superconductor layer or a first portion of a stabilizer layer, in second-generation superconductors comprising a current flow diverter layer. In addition, the process of the present invention to provide or produce a current flow diverter layer provides good coverage, thickness and, above all, the current flow diverter layer does not react with the superconductor layer or the stabilizer layer and, hence, does not affect or alter any of said layers morphology and/or properties.

Therefore, the inventors of the present invention have surprisingly found a process which is specifically useful and suited for the preparation or deposition of current flow diverter layers of the type explained above and which is useful and suited for the large-scale production of and cost-effective production of second-generation superconductor materials comprising a current flow diverter layer by means of inkjet printing. Therefore, the inventors of the present patent application effectively provide a process for the large-scale and cost-effective production of second-generation superconductor materials comprising a current flow diverter layer.

### Description of the invention

Firstly, the present invention refers to a process for the large-scale production of a superconductor material.

Moreover, the present invention also refers to a superconductor material produced in accordance with the process for the large-scale production of superconductor materials of the present invention.

In a final aspect, the present invention refers to a printing system able to and/or configured to carry out the process of the present invention.

The "used printhead" and its plural, as used herein, refers to the part of the printhead used in the process of the present invention. It may refer to a whole printhead, when said printhead has appropriate dimensions to provide the desired printhead printing area (and, hence, the desired current flow diverter layer); or it may refer to a part of the whole printhead, for example, when the whole printhead is wider or bigger than the desired printhead printing area and, hence, the desired current flow diverter layer. "Used printhead" may also refer to a plurality of printheads which, may be used to provide the printing pattern of the present invention and to provide the desired printhead printing area (and, hence, the desired current flow diverter layer).

Therefore, as already stated above, in a first aspect, the present invention refers to a process for the production of a superconductor material, said superconductor material comprising
a substrate;
a superconductor layer deposited on the substrate;
a stabilizer layer having an electrical resistance greater than the superconductor layer when said layer is in a superconducting state and lower than the superconductor layer when said layer is in a normal state, and comprising an inner surface at least partly in contact with the superconductor layer and an opposed outer surface; and
a current flow diverter layer having a greater electrical resistance than the stabilizer layer, and located between the stabilizer layer and the superconductor layer or inside the stabilizer layer, the current flow diverter layer extending between the superconductor layer and the stabilizer layer's outer surface along a portion of the width of the superconductor layer,
wherein the current flow diverter layer, in its width comprises at least one edge and a central region,
wherein the process comprises the step of inkjet-printing a current flow diverter ink onto a portion of the width of the superconductor layer when the current flow diverter layer is located between the superconductor layer and the stabilizer layer, or onto a first portion of the stabilizer layer when the current flow diverter layer is located inside the stabilizer layer, to generate the current flow diverter layer,
characterized in that in the step of inkjet-printing, the current flow diverter layer is generated by reducing the droplet density of the current flow diverter ink in the at least one edge of the current flow diverter layer with regard to the droplet density of the central region of the current flow diverter layer.

The superconductor layer is made of a material that undergoes a transition from a superconducting state to a normal state when its temperature (T) rises beyond a critical temperature (T_{c}).

The stabilizer layer has an electrical resistance greater than the superconductor layer when T is below T_{c} and an electrical resistance lower than the superconductor layer when T is equal to or above T_{c}.

The current flow diverter layer has an electrical resistance greater than the stabilizer layer when T is below T_{c} and when T is equal to or above T_{c}.

Preferably, the substrate is a biaxially-textured or polycrystalline substrate either metallic (preferably, hastelloy and/or stainless steel) or ceramic (preferably, sapphire, lanthanum aluminate and/or strontium titanate) which has a thickness of between 50 and 200 µm, more preferably, approximately 100 µm. In addition, said structure can also have other biaxially-textured or polycrystalline oxide layers, with a thickness of less than 1 µm each one.

Also preferably, the superconductor layer is also biaxially-textured and is made of REBa₂Cu₃O₇₋ₓ (wherein x is between 0 and 1), where RE is a rare-earth such as Y, Gd, Er, Sm, Nd, Dy, Eu or Ho, more preferably Y.

As stated above, the process of the present invention is a process for the production of a second-generation superconductor material comprising a current flow diverter layer.

In a preferred embodiment, the process of the present invention is a large-scale process for the production of a second-generation superconductor material comprising a current flow diverter layer. In addition, the process of the present invention is cost-effective.

Preferably, the at least one edge of the current flow diverter layer is at least one lateral edge, even more preferably, two lateral edges.

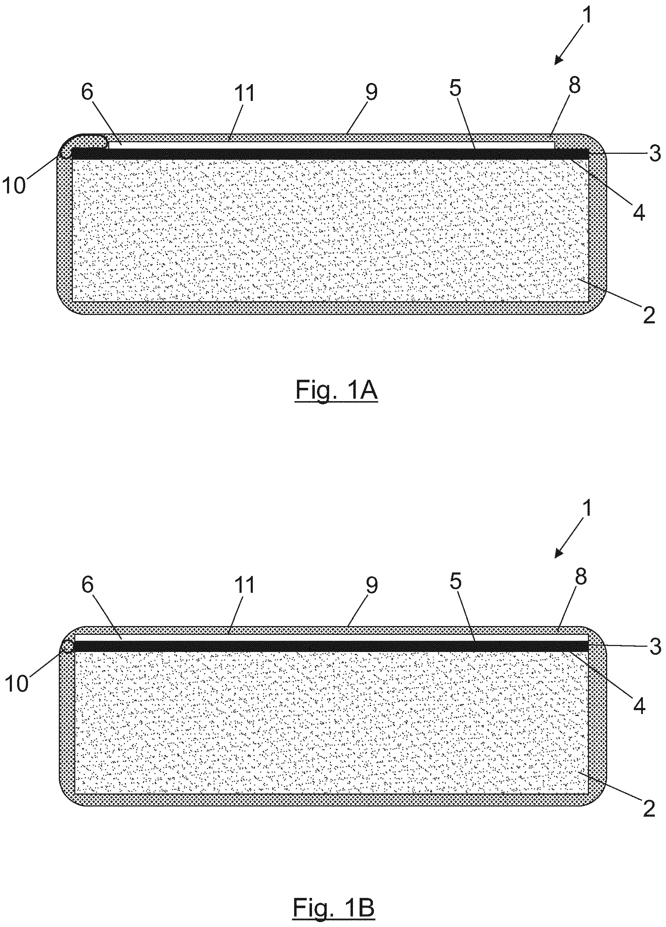

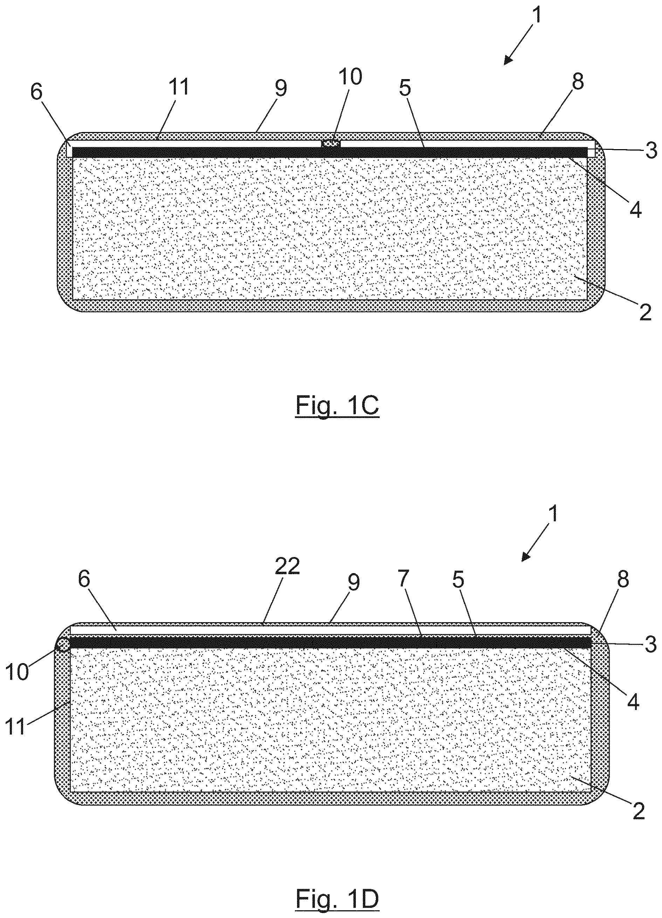

The current flow diverter layer (and, hence, the superconductor material of the present invention) can acquire any configuration known in the state of the art (see, for example, figures 1A to 1E). Preferably, the current flow diverter layer is a continuous layer. Also preferably, the current flow diverter layer is inkjet-printed in a central lane of the superconductor layer or of the first portion of the stabilizer layer.

In a preferred embodiment, in the process of the present invention, the current flow diverter layer is printed onto the superconductor layer (this is, the current flow diverter layer is located between the superconductor layer and the stabilizer layer). The superconductor layer, preferably, comprises an outer and an inner surface, wherein the superconductor layer's inner surface is in contact with the substrate and wherein between 30% and 90% of the width of the superconductor layer's outer surface is in contact with the current flow diverter layer and between 10% and 70% of the width of the superconductor layer's outer surface is in contact with the stabilizer layer's inner surface, more preferably, between 80% and 90% of the width of the superconductor layer's outer surface is in contact with the current flow diverter layer and between 10% and 20% of the width of the superconductor layer's outer surface is in contact with the stabilizer layer's inner surface.

In the most preferred embodiment the current flow diverter ink is inkjet-printed in a central lane in the superconductor layer, contacting between 80% and 90% of the width of the superconductor layer's outer surface layer and leaving between 10% and 20% of the width of the superconductor layer's outer surface not in contact with the current flow diverter layer, but in contact with the stabilizer layer's inner surface. Preferably, said between 10% and 20% of the width of the superconductor layer's outer surface not in contact with the current flow diverter layer is located in the same proportion at each side of the central lane in the superconductor layer which is in contact with the current flow diverter layer. In the most preferred embodiment, the current flow diverter layer is a central lane in the superconductor layer, contacting an 83.34% of the width of the superconductor layer's outer surface and leaving a 8.33% of the width of said superconductor layer's outer surface at each side of the central lane not in contact with the current flow diverter layer, but in contact with the stabilizer layer's inner surface.

In a further embodiment, the current flow diverter layer has a thickness of between 20 nm and 1,000 nm, more preferably between 100 nm and 200 nm, and even more preferably, has a thickness of 100 nm.

In an embodiment, in the process of the present invention, the droplet density of the current flow diverter ink is reduced between 30% and 60% in each of the two lateral edges of the current flow diverter layer. More preferably, the droplet density is reduced between 40% and 50% in each of the two lateral edges, even more preferably a 50%.

In the most preferred embodiment, the step of inkjet-printing a current flow diverter ink is carried out by means of at least one printhead comprising printing nozzles, more preferably by means of one printhead comprising printing nozzles.

Also preferably, the at least one printhead (preferably one printhead) is at a printing distance of between 1 to 3 mm (this is, distance between the printhead and the surface to be printed, this is, the superconductor layer).

Regarding the at least one printhead it is contemplated to use one or more printheads. When two or more printheads are used, they will be appropriately configured to obtain the required printing pattern. Moreover, when one printhead is used, as noted above, it can be used in full or only partly (because it may have a width or a size larger than needed for the inkjet-printing of the current flow diverter layer). Therefore, thereon in the present text reference will be made to "used printhead" to refer to the part of the printhead or printheads effectively used in the process of the present invention. The used printhead comprises at least one edge (preferably, at least one lateral edge, more preferably, two lateral edges) and a central region.

The used printhead provides for a printhead printing area which in turn comprises a central region and at least one edge (preferably, at least one lateral edge, more preferably, tow lateral edges). The width of printhead printing area corresponds with the width of the current flow diverter layer. Therefore, as used herein, the width of the at least one edge (preferably, at least one lateral edge, more preferably, tow lateral edges) of the printhead printing area and of the current flow diverter layer are equivalent or correspond each other. In addition, the width of the central region of the printhead printing area and of the central region of the current flow diverter layer are also equivalent or correspond each other.

In a preferred embodiment, in the process of the present invention, the droplet density of the current flow diverter ink is reduced between 30% and 60% in each of the two lateral edges of the printhead printing area. More preferably, the droplet density is reduced between 40% and 50% in each of the two lateral edges of the printhead printing area, even more preferably, a 50%.

Preferably, each of the two lateral edges of the printhead printing area extends between a 10% and a 25% of the total width of the printhead printing area. It is contemplated that each of the two lateral edges of the printhead printing area extends the same or different width with regard to the total width of the printhead printing area, more preferably the same width.

As can be readily ascertained, the width of the used printhead, will depend on the width of the superconductor layer. Therefore, in a preferred embodiment, the superconductor layer has a width of between 10 mm to 14 mm and, then, the used printhead has a width of between 6 mm and 10 mm and each of the two lateral edges thereof has a width of between 1 mm and 2 mm. In a most preferred embodiment, the superconductor layer has a width of 12 mm and, then, the used printhead has a width of 8 mm and each of the two lateral edges thereof has a width of 1 mm (and, therefore, the central region has 6 mm).

Therefore, in the used printhead each of the two lateral edges extends between a 5% and a 20% of the total width of the used printhead. It is contemplated that each of the two lateral edges of the used printhead extends the same or different width with regard to the width of the used printhead. In the most preferred embodiment, each of the two lateral edges of the used printhead extends a 12.5 % of the total width of the used printhead.

The at least one printhead which is preferably used to perform the inkjet-printing of the current flow diverter ink is appropriately configured to provide a printhead printing area (and, hence, the current flow diverter layer) in accordance with what has been noted above.

Any printhead known in the state of the art can be used in the process of the present invention. Examples thereof are piezoelectric, thermic and/or electromagnetic printheads. In the most preferred embodiment, the printhead is a piezoelectric printhead.

In addition, the size of the droplet can vary depending on the application, the speed of production and the thickness desired for the current flow diverter layer. In a preferred embodiment, the droplets are of between 10 and 100 pL, more preferably between 12 pL and 14 pL, even more preferably 12 pL and, as noted above, are preferably applied by means of a piezo electric printhead.

As it will be understood by the person skilled in the art the total number of activated and deactivated printing nozzles and their distribution will depend, for example, among others, on the desired features for the current flow diverter layer, the type of printhead used, the characteristics of the ink used and the droplet density.

Preferably, in each of the two lateral edges of the used printhead between 30% and 60% of the printing nozzles are deactivated, more preferably, between 40% and 50% of the printing nozzles are deactivated. In the most preferred embodiment, in each of the two lateral edges 50% of the printing nozzles are deactivated, more preferably, in an alternate manner.

In the most preferred embodiment, this is, for a 12-mm wide tape (superconductor layer of 12 mm width), in the process of the present invention the used printhead has a total of 128 printing nozzles of which 112 are active printing nozzles, preferably distributed in two banks, most preferably equally distributed in two banks (this is, a total of 64 printing nozzles per bank of which 56 are active printing nozzles). In this case, preferably, the used printhead (preferably, two banks) is configured so that in each of the two lateral edges of said used printhead between 2 and 10 printing nozzles are deactivated, more preferably, the used printhead is configured so that in each of the two lateral edges 8 printing nozzles are deactivated. Preferably, the deactivated printing nozzles in the two lateral edges, as mentioned above, are deactivated in an alternate manner, this is, the printing nozzles in said two lateral edges are alternatively activated-deactivated. In the latter, each of the two lateral edges consists of 8 activated printing nozzles and 8 deactivated printing nozzles, positioned intercalated o in an alternate manner (activated - deactivated printing nozzle).

In the most preferred embodiment, in the process of the present invention, each of the two lateral edges of each of the banks of the used printhead (preferably, two banks) consists of 8 printing nozzles which are alternatively activated-deactivated (this is, each of the two lateral edges consists of 4 activated printing nozzles and 4 deactivated printing nozzles). Therefore, in total, in the most preferred embodiment, in the process of the present invention, each of the two lateral edges of the used printhead consists of 16 printing nozzles which are alternatively activated-deactivated (this is, each of the two lateral edges consists of 8 activated printing nozzles and 8 deactivated printing nozzles)

Therefore, preferably, each of two lateral edges of the used printhead represents between a 10% and a 25% of the total width of the used printhead, even more preferably, each of the two lateral edges of the used printhead represents a 12.5% of the total width of the used printhead.

As noted above, if inkjet-printing is used to generate a current flow diverter layer but without applying the process of the present invention, the lateral edges of the current flow diverter layer appear as meniscus of a thickness at least 5 times higher than the thickness of the current flow diverter layer (for example, when the current flow diverter layer has a thickness of 100 nm, then, the above-mentioned meniscus in the two lateral edges thereof have a thickness of 500 nm or higher). Also, as noted above, said meniscus do not allow to obtain a superconductor material with acceptable superconductive features. By using the process of the present invention, the meniscus of the lateral edges of the current flow diverter layer are reduced to a thickness less than 5 times higher than the thickness of the current flow diverter layer, more preferably less than 2 times higher than the thickness of the current flow diverter layer providing, hence, a material which can be appropriately oxygenated and with appropriate superconductive features. In a preferred embodiment, the current flow diverter layer has a thickness of 100 nm and then, by using the process of the present invention, the meniscus of the lateral edges of the current flow diverter layer are reduced to less than 500 nm, more preferably to less than 200 nm, providing, hence, a material which can be appropriately oxygenated and with appropriate superconductive features.

It is contemplated that the stabilizer layer of the superconductor material produced by means of the process of the present invention is made of any material know in the state of the art to be suitable to that end. More preferably, the stabilizer layer is a layer of silver, copper, gold and/or their alloys. Even more preferably, the stabilizer layer is a silver layer.

Also, in a preferred embodiment the stabilizer layer has a thickness of between 500 nm and 1,000 nm.

The stabilizer layer can be applied or deposited by any means known in the state of the art. In the most preferred embodiment, the stabilizer layer is deposited using thermal evaporation or the sputtering technique, more preferably the stabilizer layer is deposited using thermal evaporation.

In a further preferred embodiment, the process of the present invention, after the stabilizer layer is deposited, comprises an oxygenation step, in which the superconductor material is thermally treated by means of a temperature curve which goes from a temperature of between 650°C-550°C to a temperature between 500°C-400°C by reducing from 1°C to 5°C every between 1 min and 5 min and then maintaining the final temperature (this is, between 500°C to 400°C) at least 8 hours, while being exposed, throughout said thermal treatment, to a turbulent oxygen flow (preferably, of between 0.2 l/min to 1 l/min). More preferably, in the above oxygenation step the thermal treatment consists of a temperature curve which goes from a temperature of 600°C to a temperature of 450°C by reducing 2°C/min and then the final temperature (this is, 450°C) is maintained 8 hours.

The use of this oxygenation step, as it will be apparent from the example included below, allows an appropriate oxygenation of the superconductor layer and, hence, to achieve appropriate superconductive properties for the superconductor material produced by means of the process of the present invention. On the other side, the use of an oxygenation step of the state of the art in a second-generation superconductor material comprising a current flow diverter layer does not provide for an appropriate oxygenation and, hence, does not allow to obtain materials with acceptable or appropriate superconductive properties.

This oxygenation step of the present invention as noted above allows for an appropriate oxygenation of the superconductor layer, while the one know in the state of the art does not. Therefore, the oxygenation step of the present invention (with increased treatment time and increased oxygen flux) allows to obtain superconductor materials with the required superconductive properties.

In an additional embodiment of the present invention, the inkjet-printed current flow diverter ink comprises:
- at least one metal-organic salt, preferably selected from a rare earth salt comprising at least one element selected from Y, La, Ce, Zr, Nd, Sm, Eu, Gd, Dy, Ho, Er, Yb, Lu or any combinations thereof, most preferably the rare earth salt is an Y, Gd, Ce, Zr or any combinations thereof salt, even more preferably, the rare earth salt is an yttrium salt. The counterion of said rare earth salt is, preferably, selected between monofluorocarboxylates, difluorocarboxylates, acetates (preferably, trifluoroacetates) or combinations thereof. Even more preferably, the counterion of said rare earth salt is an acetate.
- at least one additive, preferably at least one stabilizing additive, more preferably selected from stabilizing agents with carbon chains functionalized with isolated alcohol, amino, etheri or carbonyl groups or combinations thereof or polymer chains such as, for example, soluble polymers such as polyvinylpyrrolidone, polyethylene glycol, polyacrylamide or combinations thereof. Most preferably, the at least one additive is an amino alcohol, even more preferably diethanolamine.

- at least one acid, preferably selected from alkyl carboxylic acids, aryl carboxylic acids or combinations thereof, more preferably acetic acid, propionic acid, formic acid, oxalic acid, succinic acid, capric acid, hexanoic acid, benzoic acid or combinations thereof, even more preferably acetic acid, propionic acid or combinations thereof.
- a UV-sensitive varnish, preferably comprising acrylic monomers, diacrylic monomers, vinylic monomers, acrylic dimers, vinylic dimers, acrylic oligomers or combinations thereof; and a UV-sensitive photoinitiator (for example, benzophenone and azoisobutyronitrile). More preferably, the UV-sensitive varnish comprises acrylic monomers or oligomers or combinations thereof; and a UV-sensitive photoinitiator.
- at least one solvent, preferably selected from acetic acid, acetone, acetonitrile, benzene, 1-butanol, 2-butanol, 2-butanone, pentanone, t-butyl alcohol, carbon tetrachloride, chlorobenzene, chloroform, cyclohexane, 1,2-dichloroethane, diethyl ether, diethylene glycol, diethylene glycol dimethyl ether, 1,2-dimethoxyethane, dimethyl ether, dimethyl formamide, dimethylsulfoxide, dioxane, ethanol, ethyl acetate, ethylene glycol, glycerine, heptane, hexane, methanol, methyl t-butyl ether, dichloromethane, N-methyl-2-pyrrolidinone, N-methylpyrrolidone, nitromethane, pentane, petroleum ether, 1-propanol, 2-propanol, propionic acid, pyridine, tetrahydrofuran, toluene, triethylamine, o-xylene, m-xylene, p-xylene and any combinations thereof, more preferably, methanol, ethanol, 1-propanol, 2-propanol, 1-butanol or diethylene glycol or any combinations thereof, and, even more preferably 1-butanol..

More preferably, in the process of the present invention, the inkjet-printed current flow diverter ink comprises:
- the at least one metal-organic salt at a concentration of between 0.01M and 2M, more preferably of between 0.05 M and 1 M;
- the at least one additive at a concentration between 0.01 M and 2M, more preferably of between 0.05 M and 1.5 M;
- the at least one acid at a concentration of between 0.1 %(v/v) and 99%(v/v), more preferably between 10% (v/v) and 50% (v/v);
- the UV-sensitive varnish at a concentration of between 0.1%(v/v) and 99%(v/v), more preferably between 10% (v/v) and 50% (v/v);
- the at least one solvent at a concentration of between 0.1%(v/v) and 99%(v/v), more preferably between 10% (v/v) and 70% (v/v), even more preferably the at least one solvent is added to fill up.

In the most preferred embodiment, the process of the present invention is characterized in that in the inkjet-printed current flow diverter ink:
- the at least one metal-organic salt is yttrium acetate, more preferably at a concentration of between 0.01 M and 2M, even more preferably of between 0.05 M and 1 M;
- the at least one additive is diethanolamine, more preferably at a concentration between 0.01 M and 2M, even more preferably of between 0.05 M and 1.5 M;
- the at least one acid is propionic acid, more preferably at a concentration of between 0.1%(v/v) and 99%(v/v), even more preferably between 10% (v/v) and 50% (v/v);
- the UV-sensitive varnish comprises acrylic monomers, acrylic dimers and a UV-sensitive photoinitiator (preferably, at the concentration noted above); and
- the at least one solvent is 1-butanol, more preferably at a concentration of between 0.1%(v/v) and 99%(v/v), more preferably between 10% (v/v) and 70% (v/v), even more preferably the 1-butanol is added to fill-up.

In the most preferred embodiment, the process of producing a superconductor material of the present invention comprises the following steps:
a) providing a tape comprising a substrate and a superconductor layer deposited thereon, wherein the superconductor layer comprises an inner and an outer surface and wherein the inner surface is in contact with the substrate;
b) inkjet-printing the current flow diverter ink onto a portion of the outer surface of the superconductor layer when the current flow diverter layer is located between the superconductor layer and the stabilizer layer to generate the current flow diverter layer, characterized in that in the step of inkjet-printing the current flow diverter layer is generated by reducing the droplet density of the current flow diverter ink in the at least one edge of the current flow diverter layer with regard to the droplet density of the central region of the current flow diverter layer;
c) UV curing the current flow diverter layer of the superconductor material obtained in step b);
d) drying the current flow diverter layer of the superconductor material obtained in step c);
e) thermally treating the current flow diverter layer of the superconductor material obtained in step d);
f) depositing the stabilizer layer onto the current flow diverter layer and the remaining portion of the outer surface of the superconducting layer;
g) oxygenating the superconductor material obtained in step f);
h) collecting the superconductor material obtained in step g).

The superconductor material collected in step h) has the desired architecture or structure as already explained above. This is, it comprises:
a substrate;
a superconductor layer deposited on the substrate;
a stabilizer layer having an electrical resistance greater than the superconductor layer when said layer is in a superconducting state and lower than the superconducting layer when said layer is in a normal state, and comprising an inner surface at least partly in contact with the superconductor layer and an opposed outer surface; and
a current flow diverter layer having a greater electrical resistance than the stabilizer layer, and located between the stabilizer layer and the superconductor layer the current flow diverter layer extending between the superconductor layer and the stabilizer layer's outer surface along a portion of the superconductor layer.

In case the current flow diverter layer is located inside the stabilizer layer, the above-mentioned embodiment has to be modified or adapted accordingly.

Step b) of inkjet-printing is as explained above.

In a preferred embodiment, in step b) the distance between the at least one printhead (preferably, one printhead) and the tape is between 1 to 3 mm.

In a further preferred embodiment, in step c) an array of UV LEDs is used.

Also preferably, in the process of the present invention, in step d) the current flow diverter layer of the superconductor material obtained in step c) is dried by means of any method or technique known in the state of the art, preferably by means of any method or technique to produce heating of a material known in the state of the art, even more preferably step d) is carried out by means of a thermal resistance. Also preferably, step d) is carried out at a temperature of between 50°C and 80°C.

In a further preferred embodiment, in step e) of the present invention the superconductor material obtained in step d) enters a furnace (preferably, a tubular or muffle furnace; wherein a tubular furnace is normally used in a reel-to-reel continuous process and a muffle furnace is used in a batch process) wherein the thermal treatment is applied at a temperature between 300°C and 600°C.

Additionally, step f) of depositing a stabilizer layer is in accordance with what has been explained above.

In a preferred embodiment, the oxygenation step g) is in accordance with what has been explained above.

The process of the present invention solves the problems present in the state of the art and, therefore, provides a process for the production of a second-generation superconductor material comprising a current flow diverter layer which allows large-scale production of said materials in a fast and cost-effective way. The process of the present invention allows to reduce the meniscus of the edges (preferably, two lateral edges) associated with common inkjet-printing, to acceptable values; and it provides an effective oxygenation of the superconductor layer, thus, obtaining a superconductor material with the appropriate and desired superconductive features.

Moreover, the process of the present invention (including the above mentioned ink) provides for a correct deposition of an isolating oxide (for example, current flow diverter layer) onto a superconductor layer or a first portion of an stabilizer layer, in accordance with what has been explained above, providing good coverage, thickness and, above all, no reactiveness with the superconductor layer or the stabilizer layer and, hence, not affecting or altering any of said layers morphology and/or properties.

In a second aspect, the present invention refers to a superconductor material produced in accordance with the process for the productions of superconductor materials of the present invention.

In a last aspect, the present invention refers to a printing system comprising:
- a feed-in reel module;
- an inkjet printing module;
- a UV curing module;
- a drying module;
- a thermal treatment module; and
- a take-up reel module,
wherein said printing system is configured to carry out the process of the present invention.

Preferably, the feed-in reel is configured so that when the reel with the dummy tape or the tape for inkjet-printing is put on it, it can be electronically controlled for movements with the required or desired speed.

In the inkjet-printing module it is contemplated the use of any printhead known in the state of the, for example, piezoelectric, thermal and/or electromagnetic printheads. In the most preferred embodiment, the printhead is a piezoelectric printhead. In addition, also preferably, the distance between the printhead and the tape is between 1 mm and 3 mm. In addition, the inkjet-printing module may comprise one printhead or a plurality of printheads, more preferably the inkjet-printing module comprises one printhead. As noted above, the printhead is configured to carry out the process of the present invention.

Preferably, the UV curing module is an array of UV LEDs.

Also preferably, the drying module (to dry the printed ink) works at temperatures between 50°C and 80°C.

The thermal treatment module comprises a furnace (preferably, a tubular or muffle furnace; wherein a tubular furnace is normally used in a reel-to-reel continuous process and a muffle furnace is used in a batch process) where the conversion to the expected oxide is produced. This module is configured so that the process is done at a temperature between 300°C and 600°C.

The take-up reel module is to collect the superconductor material obtained.

In addition, in a preferred embodiment, the printing system of the present invention further comprises an equipment for the deposition of a stabilizer layer. Preferably, said equipment is configured to deposit a stabilizer layer in accordance with what has already been noted above.

Moreover, in a further preferred embodiment, the printing system of the present invention further comprises an equipment for oxygenation. Preferably, said equipment is configured to perform the oxygenation step in accordance with what has been explained above.

In the most preferred embodiment, the printing system of the present invention further comprises an equipment for the deposition of an stabilizer layer and an equipment for oxygenation.

To allow a better understanding, the present invention is described in more detail below with reference to the enclosed drawings, which are presented by way of example, and with reference to illustrative and non-limitative examples.

### Brief description of the drawings

Figures 1A to 1E show cross-sectional transverse views of several examples of layer layouts of superconductor materials obtained by means of the process for the production of superconductor materials of the present invention.
Figures 2A to 2C show an overview of the inkjet-printing step of the process of the present invention.
Figures 2D to 2F show an overview of an inkjet-printing step without reduction of droplet density in the two lateral edges of the printhead printing area.
Figures 3A and 3B show the Hall maps obtained in Example 2.
Figures 4A and 4B show the Hall maps obtained in Example 3.
Figure 5 shows a Cross-Sectional Scanning Electron Microscopy cross-section image of a superconductor material of the present invention as obtained in Example 4.

### Detailed description of the drawings

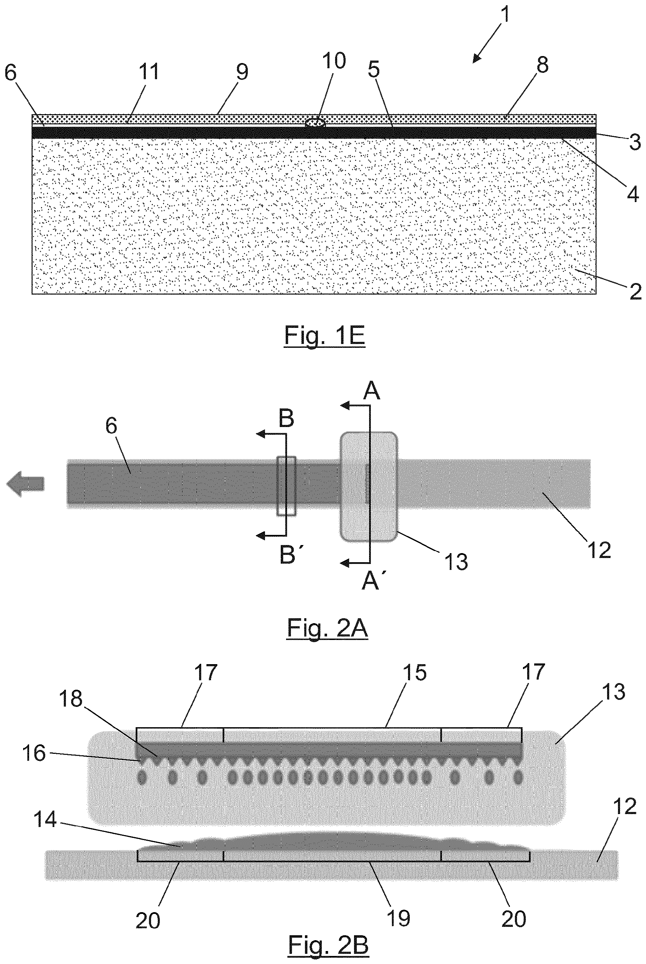

As already stated above, figures 1A to 1E show cross-sectional transverse views of several examples of layer layouts of superconductor materials (1) obtained by means of the process for the production of superconductor materials of the present invention. In all said figures it can be seen a substrate (2), with a superconductor layer (3) deposited thereon, wherein the superconductor layer (3) comprises a superconductor layer's inner surface (4) and a superconductor layer's outer surface (5). In addition, the current flow diverter layer (6) is deposited onto a portion of the superconductor layer's outer surface (5) (figures 1A to 1C and 1E) or onto a first portion (7) of a stabilizer layer (8) (figure 1D). In addition, in figure 1D we also find a second portion (22) of the stabilizer layer (8), wherein the first portion (7) of the stabilizer layer (8) is deposited on the superconductor layer's outer surface (5); and the current flow diverter layer (6) is located between the first portion (7) of the stabilizer layer (8) and the second portion (22) of the stabilizer layer (8).

Finally, in figures 1A to 1E we also find the stabilizer layer (8). As noted above, the current flow diverter layer (6) is located between the stabilizer layer (8) and the superconductor layer (3) or inside the stabilizer layer (8). Therefore, said current flow diverter layer (6) extends between the superconductor layer (3) and the stabilizer layer's outer surface (9) along a portion of the superconductor layer (3) and provides or allows for points of direct contact (10) between the stabilizer layer (8) and the superconductor layer (3), wherein no current flow diverter layer (6) is found between the superconductor layer (3) and the stabilizer layer's outer surface (9). In figures 1A to 1E the stabilizer layer's inner surface (11) can also be seen and which is partly in contact (see points of direct contact (10)) with the superconductor layer (3).

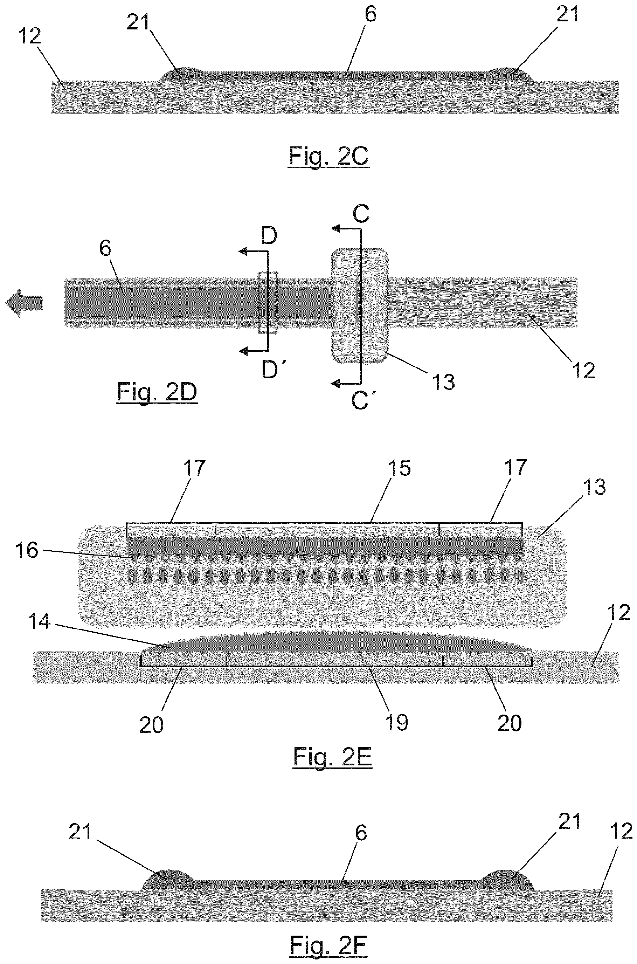

Figures 2A to 2C show an overview of the inkjet-printing step in the process of the present invention and figures 2D to 2F show an inkjet-printing step wherein all printing nozzles of the printhead located in the printhead printing area are activated. In figure 2A we can see an overview of the movement of tape (12) (substrate (2) with the superconductor layer (3) deposited thereon) before being printed, going across the used printhead (13) so that the current flow diverter ink is deposited in a portion of the superconductor layer (3) (in this case centered and covering an 83.33% of the width of the superconductor layer (3); leaving a 16.67% of the width of the superconductor layer (3) without coverage in each of the lateral edges thereof) and after the current flow diverter layer (6) has been deposited (movement in figure 2A is from right to left, as noted by the corresponding solid arrow).

Figure 2B corresponds to the cross-section A-A' noted in figure 2A. In figure 2B, the used printhead (13), in the printhead printing area (14), comprises in its width: a used printhead central region (15) with activated printing nozzles (16) and two used printhead lateral edges (17) with alternate activated printing nozzles (16) and deactivated printing nozzles (18). Also, in figure 2B it can be seen the printhead printing area (14) which corresponds to the current flow diverter layer (6) when being deposited in the tape (12) (onto de superconductor layer (3) of the tape (12)). Said printhead printing area (14) comprises, in its width, a printhead printing area central region (19) and two printhead printing area lateral edges (20), wherein said lateral edges (20), in accordance with what has been stated above, show a reduced droplet density, with regard to the said central region (19).

Figure 2C corresponds to the cross-section B-B' noted in figure 2A and shows the current flow diverter layer (6) already deposited in tape (12). As can be seen, the current flow diverter layer (6) in figure 2C shows an almost uniform surface with minimal meniscus (21) in the lateral edges thereof (this is, a surface wherein the meniscus in the two lateral edges of the current flow diverter layer (6) have been reduced to acceptable values, preferably meniscus (21) with a thickness less than 5 times higher than the thickness of the central region of the current flow diverter layer (6), more preferably less than 2 times higher than the thickness of the central region of the current flow diverter layer (6). For example, if the central region of the current flow diverter layer (6) has a thickness of 100 nm, by using the process of the present invention, the meniscus (21) of the lateral edges of the current flow diverter layer (6) are reduced to less than 500 nm, more preferably to less than 200 nm.

As noted above, figures 2D to 2F show an inkjet-printing step wherein all printing nozzles of the printhead located in the printhead printing area are activated (this is, without reduction of droplet density in the two lateral edges of the printhead printing area or of the current flow diverter layer), different from that of the present invention.

In figures 2D to 2F similar structures as those explained for figures 2A to 2C can be seen. Briefly, in figure 2D we can see an overview of the movement of tape (12) (substrate (2) with the superconductor layer (3) deposited thereon) before being printed, going across the used printhead (13) so that the current flow diverter ink is deposited in a portion of the superconductor layer (3) (in this case centered and covering approximately an 83% of the width of the superconductor layer (3); leaving approximately a 17% of the width of the superconductor layer (3) without coverage in each of the lateral edges thereof) and after the current flow diverter layer (6) has been deposited (movement in figure 2D is from right to left, as noted by the corresponding solid arrow).

Figure 2E, corresponds to the cross-section C-C' noted in figure 2D. In figure 2E, the used printhead (13), in the printhead printing area (14), comprises in its width: only activated printing nozzles (16) (both in the used printhead central region (15) and in the two used printhead lateral edges (17)). Also, in figure 2E it can be seen the printhead printing area (14) which corresponds to the current flow diverter layer when being deposited in the tape (12) (onto de superconductor layer (3) of the tape (12)). Said printhead printing area (14) comprises, in its width, a printhead printing area central region (19) and two printhead printing area lateral edges (20). In this case there is no droplet density reduction in said two lateral edges (20) with regard to said central region (19).

Figure 2F corresponds to the cross-section D-D' noted in figure 2D and shows the current flow diverter layer (6) already deposited in tape (12). As can be seen, the current flow diverter layer (6) in figure 2F shows a high meniscus (21) in each of the two lateral edges thereof (of thickness at least 5 times higher than the thickness of the central region of the current flow diverter layer (6) - for example, when the central region of the current flow diverter layer (6) has a thickness of 100 nm, then, meniscus (21) in each of the two lateral edges of the current flow diverter layer (6) has a thickness of 500 nm or higher).

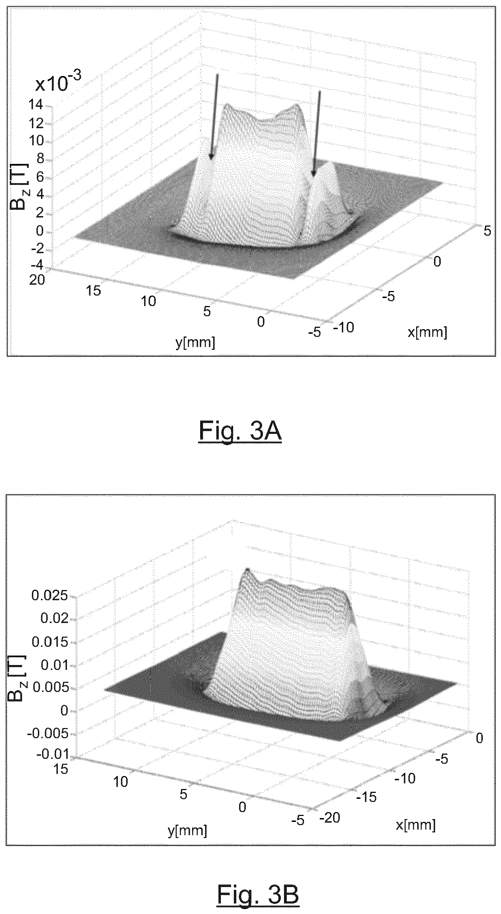

Figure 3, as already noted above, shows the Hall maps obtained in Example 2. Figure 3A shows the Hall map for a superconductor material obtained without alternate deactivation of printing nozzles in the two lateral edges of the used printhead. In figure 3A, the two arrows show the effect of the high meniscus in the two lateral edges of the current flow diverter layer). On its side, figure 3B shows the Hall map for a superconductor material obtained with a process of the present invention. The Hall maps of figures 3A and 3B show a three-dimensional map of the magnetic field at a certain height with regard to the sample. The y axis of both figures shows the vertical component of the magnetic field (Bz), in Teslas. The axis x and z of both figures show the position in the sample, in mm.

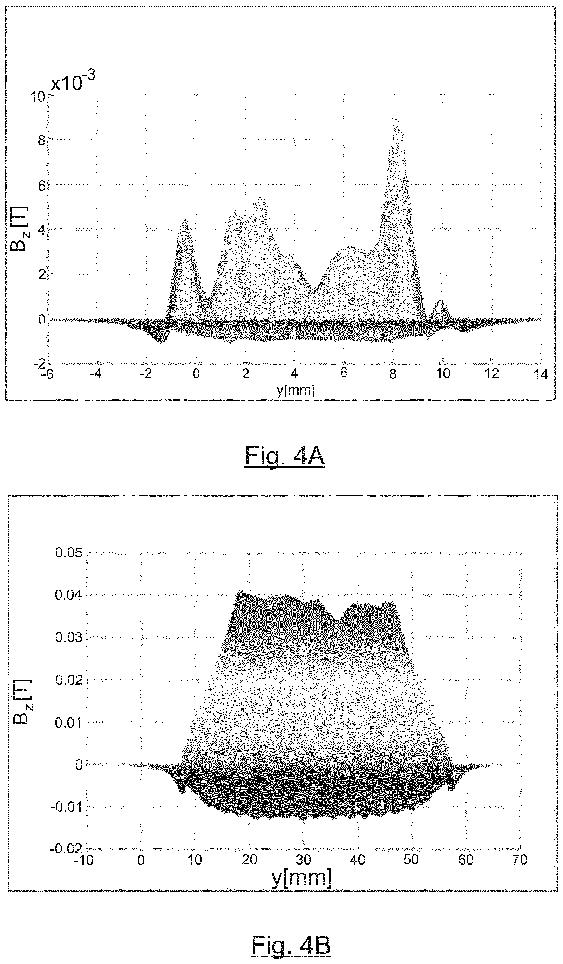

Figure 4 shows the Hall maps obtained in Example 3. Figure 4A shows the Hall map for a superconductor material obtained by performing a standard oxygenation step (known in the state of the art). On its side, figure 4B shows the Hall map for a superconductor material obtained with a process of the present invention, this is, by performing the oxygenation step in accordance with the present invention. The Hall maps of figures 4A and 4B show longitudinal projections of the magnetic field at a certain height with regard to the sample. The y axis of both figures shows the vertical component of the magnetic field (Bz), in Teslas. The axis x of both figures shows the position in the sample, in mm.

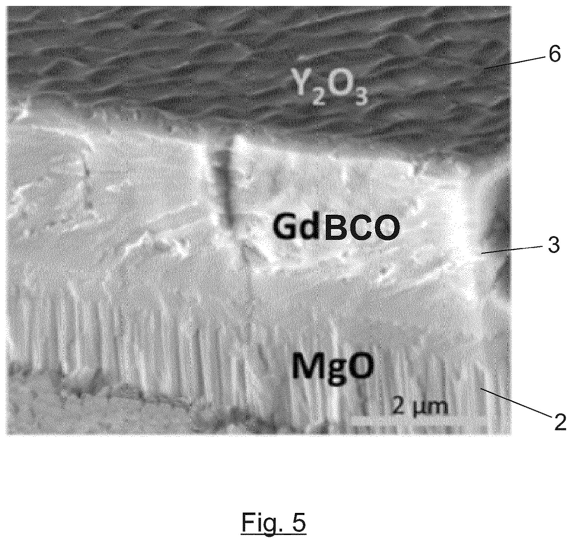

Figure 5 shows a Cross-Sectional Scanning Electron Microscopy image of the superconductor material in accordance with Example 4. In said figure 5, we can see the substrate (2), the superconductor layer (3) and the current flow diverter layer (6).

### Examples

### Example 1. Production of a superconductor material by means of a process of the present invention.

A 12-mm width metallic tape (provided by THEVA DÜNNSCHICHTTECHNIK) with architecture GdBCO/MgO/Hastelloy was used. This tape was put on the coil from the feed-in reel module and then electronically controlled for movements with speeds between 20 - 50 m/h.

The deposition of the current flow diverter layer was done in the inkjet-printing module by inkjet-printing the current flow diverter ink by means of a piezoelectric printhead from Konica Minolta consisting of 2 banks of 256 printing nozzles (total of 512 printing nozzles), using a total of 64 printing nozzles per bank among which 56 printing nozzles were active. Said 64 printing nozzles per bank were located in region of the two banks used for the printing of the above-mentioned tape. In addition, regarding said 64 printing nozzles per bank it is important to note that they corresponded to a central region with all printing nozzles activated and two lateral edges each with 4 activated printing nozzles and 4 deactivated printing nozzles (in an alternate manner, this is, printing nozzles were alternatively activated-deactivated in each of the two lateral edges). The printheads were mechanically centered on the tape and distance between the printhead and the tape was 1-3 mm.

The current flow diverter layer was printed to a thickness of 100 nm centered onto the superconductor layer (covering 83.34% of the width of the superconductor layer - this is 10 mm out of the total 12 mm mentioned above - and leaving approximately 8.33% of width in each side of the superconductor layer without covering - this is, leaving in each side one mm of the 12 mm mentioned above -; this coverage does not exactly match with the used printhead due to the scatter of the current flow diverter ink when printed, and this case the used printhead corresponded to 8 mm centered on the above-mentioned tape) and by reducing a 50% the droplet density of the ink in each of the two lateral edges of the current flow diverter layer or printhead printing area (as it is readily derivable from the printing nozzle configuration explained above). The droplet density reduction, as explained above, was achieved by means of alternate deactivation of the corresponding printing nozzles. It is noted that current flow diverter ink used was an yttrium oxide precursor solution which comprised:
- yttrium acetate;
- diethanolamine;
- propionic acid;
- a UV-sensitive varnish; and
- 1-butanol to fill up,
all in accordance with what has been explained above.

Subsequently, current flow diverter layer obtained was UV cured by means of an array of 10 cm to 25 cm of UV LEDs with wavelength between 275-295 nm. Afterwards, the printed current flow diverter inks were dried by longitudinally moving the inkjet printed tape on a 50 cm to 200 cm thermal resistance at temperatures between 50°C and 80°C. Then, the dried tape was entered in a tubular furnace (of 50 cm to 200 cm) where the conversion of the expected oxide of the current flow diverter layer was produced. The process in this module was done in air at a temperature between 400 °C and 600 °C with a velocity of 0.2-0.5 m/h. Subsequently, the converted tape was collected on the take-up reel. To achieve the expected superconducting properties of the superconductor material the following additional steps were performed:
- Deposition of a silverfilm or layer (of between 500 nm to 1,000 nm) by means of thermal evaporation; and
- Oxygenation step: thermal processing (thermal curve wherein temperature is reduced from 600°C to 450 °C at a rate or speed of temperature reduction of 2°/min and, afterwards, a temperature of 450°C was maintained during 8 hours) of the superconductor material under oxygen flow (0.2 - 1 l/min).

### Example 2. Comparison of a superconductor material obtained by means of a process of the present invention and a superconductor material obtained by means of a process in which all printing nozzles of the used printhead in the printhead printing area are activated.

A superconductor material was prepared in accordance with the process noted in example 1 (this is, a process for the production of a superconductor material of the present invention).

In addition, a superconductor material following the procedure or process of example 1 but with the sole exception that all printing nozzles in the used printhead were activated (this is, there was no droplet density reduction in the two lateral edges of the current flow diverter layer or the printhead printing area) was also prepared.

In this case, Hall mapping of vertical component of trapped magnetic field at 77 K was performed on short lengths of the final tape or superconductor materials mentioned above, by scanning the whole surface after Field-Cooled magnetization. The Hall probe was in close contact with the sample (less than 0.5 mm typically). Data was represented as a 3D graphic of Bz-x-y (this is, the vertical component of the magnetic field - measured in Teslas - with regard to the position in the analysed sample - measured in mm -).

The results obtained appear summarized in figures 2 and 3.

As can be derived from figures 2C and 2F, wherein it is schematically represented the current flow diverter layer structure obtained in each of the twos cases tested, when all printing nozzles in the used printhead are activated and, hence, the droplet density is not reduced, high meniscus (of 500 nm or greater) are formed in each of the two lateral edges of the current flow diverter layer (while the central region of the current flow diverter layer has a thickness of 100 nm). Instead, when droplet density is reduced in each of the two lateral edges of the current flow diverter layer as in the process of the present invention, said high meniscus mentioned above disappear or almost disappear and provide a current flow diverter layer with minimal meniscus (approximately less than 200 nm).

In figure 3 a Hall map of each of the two superconductor materials tested can be seen. As it is directly derivable from figure 3A, when there is no reduction of the droplet density, the thicker edges of the current flow diverter layer cause a decrease of the trapped magnetic field providing a superconductor material with unacceptable superconducting properties. On the other side, the superconductor material obtained by means of the process of the present invention showed a more homogeneous Hall map with no decrease in the edges thereof and, hence, providing for appropriate superconducting properties (see figure 3B).

### Example 3. Comparison of a superconductor material obtained by means of a process of the present invention and a superconductor material obtained by means of a process in which a standard oxygenation step was used.

A superconductor material was prepared in accordance with the process noted in example 1 (this is, a process for the production of a superconductor material of the present invention).

In addition, a superconductor material following the procedure or process of example 1 but with the sole exception that a standard oxygenation step in a tubular furnace with a pure oxygen flow of 0.12 l/min in normal conditions (as used and know in the state of the art) was used (this is, there was no droplet density reduction in the two lateral edges of the current flow diverter layer or the printhead printing area) was also prepared.

Briefly, the standard oxygenation step (as used and known in the state of the art) was a thermal processing (thermal curve wherein temperature was reduced from 600 °C to 450 °C at a rate or speed of temperature reduction of 2°/min and, afterwards, a temperature of 450°C was maintained during 2 hours) of the superconductor material under oxygen flow of 0.12 l/min (normal flow, not turbulent).

In this case, Hall mapping of vertical component of trapped magnetic field at 77 K was performed on short lengths of the final tape or superconductor materials mentioned above, by scanning the whole surface after Field-Cooled magnetization. The Hall probe was in close contact with the sample (less than 0.5 mm typically). Data was represented as a projection of Bz (vertical component of the magnetic field; as measured in Teslas) along the length of the tape (as measured in mm).

The results obtained appear summarized in figure 4.

As can be directly derived from figure 4A, when a standard oxygenation step was used, the Hall map obtained was altered and the superconductor material, hence, did not show appropriate superconductive properties, due to the inappropriate oxygenation of the superconductor layer. On the other side, the superconductor material obtained by means of the process of the present invention showed a more homogeneous Hall map with, providing for appropriate superconducting properties (see figure 4 (B)).

### Example 4. Analysis of the reactivity (including morphology and architecture) of the current flow diverter layer printed in accordance with the process of the present invention and the superconductor layer.

A superconductor material was prepared in accordance with the process noted in example 1 (this is, a process for the production of a superconductor material of the present invention), but without the additional steps of depositing a silver layer and of oxygenation.

Then, the obtained material was analysed by means of Cross-Sectional Scanning Electron Microscopy and the results obtained appear in figure 5.

Briefly, Cross-Sectional Scanning Electron Microscopy was made on a JEOL Field Emission-SEM device after careful cutting of the superconductor material mentioned above with sharp scissors and mounting on a tilted support.

In said figure 5 it can be seen that the current flow diverter layer (obtained by means of the process of the present invention) has correct coverage and has no reactivity with the superconductor layer (GdBCO) as both layers can be individually identified and no reaction layer at the interface GdBCO and current flow diverter layer was observed and, hence, does not alter the structure and properties of said superconductor layer.

## Claims

1. Process for the production of a superconductor material, said superconductor material comprising
a substrate (2); a superconductor layer (3) deposited on the substrate; a stabilizer layer (8) having an electrical resistance greater than the superconductor layer (3) when said layer is in a superconducting state and lower than the superconductor layer (3) when said layer is in a normal state, and comprising an inner surface (11) at least partly in contact with the superconductor layer (3) and an opposed outer surface (9); and a current flow diverter layer (6) having a greater electrical resistance than the stabilizer layer (8), and located between the stabilizer layer (8) and the superconductor layer (3) or inside the stabilizer layer (8), the current flow diverter layer (6) extending between the superconductor layer (3) and the stabilizer layer's outer surface (9) along a portion of the width of the superconductor layer (3), wherein the current flow diverter layer (6), in its width comprises at least one edge and a central region,
wherein the process comprises the step of inkjet-printing a current flow ink onto a portion of the width of the superconductor layer (3) when the current flow diverter layer (6) is located between the superconductor layer (3) and the stabilizer layer (8), or onto a first portion of the stabilizer layer (8) when the current flow diverter layer (6) is located inside the stabilizer layer (8), to generate the current flow diverter layer (6), **characterized in that** in the step of inkjet-printing, the current flow diverter layer (6) is generated by reducing the droplet density of the current flow diverter ink in the at least one edge of the current flow diverter layer (6) with regard to the droplet density of the central region of the current flow diverter layer (6).

2. Process in accordance with claim 1, **characterized in that** the at least one edge of the current flow diverter layer is two lateral edges.

3. Process in accordance with claim 1 or claim 2, **characterized in that** the droplet density of the current flow diverter ink in the at least one edge of the current flow diverter layer is reduced between a 30% and a 60%.

4. Process in accordance with any one of claims 1 to 3, **characterized in that** the step of inkjet-printing a current flow diverter ink is carried out by means of at least one printhead comprising printing nozzles, wherein said at least one printhead provides a used printhead (13) and a printhead printing area (14) comprising a central region (15) and two lateral edges (17).

5. Process in accordance with claim 4, **characterized in that** each of the two lateral edges of the printhead printing area extends between a 10% and a 25% of the total width of the printhead printing area.

6. Process in accordance with claim 4 or claim 5, **characterized in that** the used printhead comprises two lateral edges and a central region, wherein said used printhead is configured so that in each of the two lateral edges of the used printhead between 30% and 60% of the printing nozzles are deactivated.

7. Process in accordance with claim 6, **characterized in that** in each of the two lateral edges of the used printhead a 50% of the printing nozzles are deactivated

8. Process in accordance with claim 7, **characterized in that** in each of the two lateral edges of the used printhead, printing nozzles are deactivated in an alternate manner.

9. Process in accordance with any one of claims 1 to 8, **characterized in that** the superconductor layer (3) comprises a superconductor layer's outer surface (5) and a superconductor layer's inner surface (4), wherein said inner surface (4) is in contact with the substrate (2) and wherein between 30-90% of the width of said outer surface (5) is in contact with the current flow diverter layer (6) and between 10-70% of the width of said outer surface (5) is in contact with the stabilizer layer's inner surface (11).

10. Process in accordance with claim 9, **characterized in that** the current flow diverter layer is inkjet-printed in a central lane of the superconductor layer and wherein between 80-90% of the width of the superconductor layer's outer surface is in contact with the current flow diverter layer and between 10-20% of the width of the superconductor layer's outer surface is in contact with the stabilizer layer's inner surface of the stabilizer layer.

11. Process in accordance with any one of claims 1 to 10, **characterized in that** the printhead is a piezoelectric printhead.

12. Process in accordance with any one of claims 1 to 11, **characterized in that**, after the stabilizer layer is deposited, an oxygenation step is performed, in which the superconductor material is thermally treated with a temperature curve which goes from a temperature of between 650°C-550°C to a temperature between 500°C-400°C by reducing from 1°C to 5°C every between 1 min and 5 min and then maintaining the final temperature at least 8 hours, while being exposed to a turbulent oxygen flow.

13. Process in accordance with claim 12, **characterized in that** in the oxygenation step the superconductor material is thermally treated with a temperature curve which goes from a temperature of between 600°C to a temperature of 450°C by reducing 2°C/min and then maintaining a temperature of 450°C during 8 hours, while being exposed to an oxygen flow of 0.2 l/min to 1 l/min.

14. Process in accordance with any one of claims 1 to 13, **characterized in that** the stabilizer layer is a silver layer.

15. Process in accordance with any one of claims 1 to 14, **characterized in that** the process comprises the following steps:
a) providing a tape (12) comprising a substrate (2) and a superconducting layer (3) deposited thereon, wherein the superconductor layer comprises a superconductor layer's inner surface (4) and a superconductor layer's outer surface (5) and wherein said inner surface is in contact with the substrate;
b) inkjet-printing the current flow diverter ink onto a portion of the outer surface of the superconductor layer when the current flow diverter layer is to be located between the superconductor layer and the stabilizer layer to generate the current flow diverter layer (6);
c) UV curing the current flow diverter layer of the superconductor material obtained in step b);
d) drying the current flow diverter layer of the superconductor material obtained in step c);
e) thermally treating the current flow diverter layer of the superconductor material obtained in step d);
f) depositing the stabilizer layer onto the current flow diverter layer and the remaining portion of the outer surface of the superconducting layer;
g) oxygenating the superconductor material obtained in step f);
h) collecting the superconductor material obtained in step g),
**characterized in that** in the step of inkjet-printing the current flow diverter layer is generated by reducing the droplet density of the current flow diverter ink in the at least one edge of the current flow diverter layer with regard to the droplet density of the central region of the current flow diverter layer.

## Patentansprüche

1. Verfahren zur Herstellung eines Supraleitermaterials, wobei das genannte Supraleitermaterial Folgendes umfasst
ein Substrat (2);
eine auf dem Substrat aufgebrachte Supraleiterschicht (3);
eine Stabilisatorschicht (8) mit einem elektrischen Widerstand, der höher ist als der der Supraleiterschicht (3), wenn sich die genannte Schicht in einem supraleitenden Zustand befindet und niedriger ist als der der Supraleiterschicht (3), wenn sich die genannte Schicht in einem normalen Zustand befindet, sowie einer zumindest teilweise in Kontakt mit der Supraleiterschicht (3) befindlichen Innenfläche (11) und einer gegenüberliegenden Außenfläche (9); und
eine Stromflussumlenkschicht (6) mit einem höheren elektrischen Widerstand als die Stabilisatorschicht (8), die zwischen der Stabilisatorschicht (8) und der Supraleiterschicht (3) oder innerhalb der Stabilisatorschicht (8) angeordnet ist, wobei sich die Stromflussumlenkschicht (6) zwischen der Supraleiterschicht (3) und der Außenfläche (9) der Stabilisatorschicht entlang eines Teils der Breite der Supraleiterschicht (3) erstreckt,
wobei die Stromflussumlenkschicht (6) innerhalb ihrer Breite mindestens einen Rand und einen mittleren Bereich umfasst,
wobei das Verfahren zwecks Erzeugens der Stromflussumlenkschicht (6) den Schritt des Tintenstrahlaufdruckens von Stromflusstinte umfasst, und zwar auf einen Teil der Breite der Supraleiterschicht (3), wenn die Stromflussumlenkschicht (6) zwischen der Supraleiterschicht (3) und der Stabilisatorschicht (8) angeordnet ist, oder auf einen ersten Teil der Stabilisatorschicht (8), wenn die Stromflussumlenkschicht (6) innerhalb der Stabilisatorschicht (8) angeordnet ist, **dadurch gekennzeichnet, dass** beim Schritt des Tintenstrahlaufdruckens die Stromflussumlenkschicht (6) durch Verringern der Tröpfchendichte der Stromflussumlenktinte in dem mindestens einen Rand der Stromflussumlenkschicht (6) im Vergleich zur Tröpfchendichte im mittleren Bereich der Stromflussumlenkschicht (6) erzeugt wird.

2. Verfahren nach Anspruch 1, **dadurch gekennzeichnet, dass** der mindestens eine Rand der Stromflussumlenkschicht aus zwei seitlichen Rändern besteht.

3. Verfahren nach Anspruch 1 oder Anspruch 2, **dadurch gekennzeichnet, dass** die Tröpfchendichte der Stromflussumlenktinte in dem mindestens einen Rand der Stromflussumlenkschicht zwischen 30% und 60% verringert ist.

4. Verfahren nach einem der Ansprüche 1 bis 3, **dadurch gekennzeichnet, dass** der Schritt des Tintenstrahlaufdruckens von Stromflussumlenktinte durch mindestens einen Druckkopf mit Druckdüsen durchgeführt wird, wobei der genannte mindestens eine Druckkopf einen verwendeten Druckkopf (13) und einen Druckkopfdruckbereich (14) mit einem mittleren Bereich (15) und zwei seitlichen Rändern (17) umfasst.

5. Verfahren nach Anspruch 4, **dadurch gekennzeichnet, dass** jeder der beiden seitlichen Ränder des Druckkopfdruckbereichs zwischen 10% und 25% der Gesamtbreite des Druckkopfdruckbereichs einnimmt.

6. Verfahren nach Anspruch 4 oder Anspruch 5, **dadurch gekennzeichnet, dass** der verwendete Druckkopf zwei seitliche Ränder und einen mittleren Bereich umfasst, wobei der genannte verwendete Druckkopf so ausgestaltet ist, dass in jedem der beiden seitlichen Ränder des verwendeten Druckkopfs zwischen 30% und 60% der Druckdüsen deaktiviert sind.

7. Verfahren nach Anspruch 6, **dadurch gekennzeichnet, dass** in jedem der beiden seitlichen Ränder des verwendeten Druckkopfs jeweils 50% der Druckdüsen deaktiviert sind.

8. Verfahren nach Anspruch 7, **dadurch gekennzeichnet, dass** in jedem der beiden seitlichen Ränder des verwendeten Druckkopfs Druckdüsen in abwechselnder Anordnung deaktiviert sind.

9. Verfahren nach einem der Ansprüche 1 bis 8, **dadurch gekennzeichnet, dass** die Supraleiterschicht (3) eine Außenfläche (5) der Supraleiterschicht und eine Innenfläche (4) der Supraleiterschicht aufweist, wobei die genannte Innenfläche (4) in Kontakt mit dem Substrat (2) ist und wobei 30-90% der Breite der genannten Außenfläche (5) in Kontakt mit der Stromflussumlenkschicht (6) sind und 10-70% der Breite der genannten Außenfläche (5) in Kontakt mit der Innenfläche (11) der Stabilisatorschicht sind.

10. Verfahren nach Anspruch 9, **dadurch gekennzeichnet, dass** die Stromflussumlenkschicht in einer mittleren Bahn der Supraleiterschicht tintenstrahlaufgedruckt wird und wobei 80-90% der Außenflächenbreite der Supraleiterschicht mit der Stromflussumlenkschicht in Kontakt sind und 10-20% der Außenflächenbreite der Supraleiterschicht mit der Innenfläche der Stabilisatorschicht in Kontakt sind.

11. Verfahren nach einem der Ansprüche 1 bis 10, **dadurch gekennzeichnet, dass** der Druckkopf ein piezoelektrischer Druckkopf ist.

12. Verfahren nach einem der Ansprüche 1 bis 11, **dadurch gekennzeichnet, dass** nach dem Aufbringen der Stabilisatorschicht ein Sauerstoffbeladungsschritt durchgeführt wird, bei dem das Supraleitermaterial mit einer Temperaturkurve, die sich von einer Temperatur zwischen 650°C-550°C auf eine Temperatur zwischen 500°C-400°C bewegt, thermisch behandelt wird, wobei die Temperatur alle 1 Minute bis 5 Minuten um 1°C bis 5°C gesenkt wird und die Endtemperatur dann mindestens 8 Stunden gehalten wird, während ein verwirbelter Sauerstoffstrom auf das Material einwirkt.

13. Verfahren nach Anspruch 12, **dadurch gekennzeichnet, dass** das Supraleitermaterial beim Sauerstoffbeladungsschritt mit einer Temperaturkurve, die sich von zwischen 600°C Temperatur auf 450°C Temperatur bewegt, thermisch behandelt wird, wobei die Temperatur um 2°C/min gesenkt und anschließend 8 Stunden lang auf 450°C gehalten wird, während ein Sauerstoffstrom von 0.2 l/min bis 1 l/min auf das Material einwirkt.

14. Verfahren nach einem der Ansprüche 1 bis 13, **dadurch gekennzeichnet, dass** die Stabilisatorschicht eine Silberschicht ist.

15. Verfahren nach einem der Ansprüche 1 bis 14, **dadurch gekennzeichnet, dass** das Verfahren die folgenden Schritte umfasst:
a) Bereitstellen eines Bandes (12), das ein Substrat (2) und eine darauf aufgebrachte Supraleiterschicht (3) umfasst, wobei die Supraleiterschicht eine Innenfläche (4) der Supraleiterschicht und eine Außenfläche (5) der Supraleiterschicht aufweist und wobei die genannte Innenfläche in Kontakt mit dem Substrat ist;
b) Tintenstrahlaufdrucken von Stromflussumlenktinte auf einen Teil der Außenfläche der Supraleiterschicht zwecks Erzeugens der Stromflussumlenkschicht (6), wenn die Stromflussumlenkschicht zwischen der Supraleiterschicht und der Stabilisatorschicht angeordnet sein soll;
c) UV-Härten der Stromflussumlenkschicht des in Schritt b) erzielten Supraleitermaterials;
d) Trocknen der Stromflussumlenkschicht des in Schritt c) erzielten Supraleitermaterials;
e) thermische Behandlung der Stromflussumlenkschicht des in Schritt d) erzielten Supraleitermaterials;
f) Aufbringen der Stabilisatorschicht auf die Stromflussumlenkschicht und den restlichen Teil der Außenfläche der Supraleiterschicht;
g) Sauerstoffbeladung des in Schritt f) erzielten Supraleitermaterials;
h) Entnahme des in Schritt g) erzielten Supraleitermaterials,
**dadurch gekennzeichnet, dass** beim Schritt des Tintenstrahlaufdruckens die Stromflussumlenkschicht durch Verringern der Tröpfchendichte der Stromflussumlenktinte in dem mindestens einen Rand der Stromflussumlenkschicht im Vergleich zur Tröpfchendichte im mittleren Bereich der Stromflussumlenkschicht erzeugt wird.

## Revendications

1. Procédé de production d'un matériau supraconducteur, ledit matériau supraconducteur comprenant
un substrat (2) ;
une couche supraconductrice (3) déposée sur le substrat ;
une couche stabilisatrice (8) ayant une résistance électrique supérieure à celle de la couche supraconductrice (3) lorsque ladite couche est dans un état supraconducteur et inférieure à celle de la couche supraconductrice (3) lorsque ladite couche est dans un état normal, et comprenant une surface intérieure (11) au moins partiellement en contact avec la couche supraconductrice (3) et une surface extérieure opposée (9) ; et
une couche de déviation du flux de courant (6) ayant une résistance électrique supérieure à celle de la couche stabilisatrice (8), et située entre la couche stabilisatrice (8) et la couche supraconductrice (3) ou à l'intérieur de la couche stabilisatrice (8), la couche de déviation du flux de courant (6) s'étendant entre la couche supraconductrice (3) et la surface extérieure (9) de la couche stabilisatrice le long d'une partie de la largeur de la couche supraconductrice (3),
dans lequel la couche de déviation du flux de courant (6), dans sa largeur, comprend au moins un bord et une région centrale,
dans lequel le procédé comprend l'étape consistant à imprimer par jet d'encre une encre de flux de courant sur une partie de la largeur de la couche supraconductrice (3) lorsque la couche de déviation du flux de courant (6) est située entre la couche supraconductrice (3) et la couche stabilisatrice (8), ou sur une première partie de la couche stabilisatrice (8) lorsque la couche de déviation du flux de courant (6) est située à l'intérieur de la couche stabilisatrice (8), pour générer la couche de déviation de flux de courant (6), **caractérisé en ce que** dans l'étape d'impression à jet d'encre, la couche de déviation de flux de courant (6) est générée en réduisant la densité de gouttelettes de l'encre de déviation de flux de courant dans au moins un bord de la couche de déviation de flux de courant (6) par rapport à la densité de gouttelettes de la région centrale de la couche de déviation de flux de courant (6).

2. Procédé selon la revendication 1, **caractérisé en ce qu'au** moins un bord de la couche de déviation d'écoulement actuel est deux bords latéraux.

3. Procédé selon la revendication 1 ou la revendication 2, **caractérisé en ce que** la densité de gouttelettes de l'encre de déviation du courant dans l'au moins un bord de la couche de déviation du courant est réduite entre 30% et 60%.

4. Procédé selon l'une quelconque des revendications 1 à 3, **caractérisé en ce que** l'étape d'impression par jet d'encre d'une encre de dérivation de courant est réalisée au moyen d'au moins une tête d'impression comprenant des buses d'impression, dans lequel ladite au moins une tête d'impression fournit une tête d'impression utilisée (13) et une zone d'impression de tête d'impression (14) comprenant une région centrale (15) et deux bords latéraux (17).

5. Procédé selon la revendication 4, **caractérisé en ce que** chacun des deux bords latéraux de la zone d'impression de la tête d'impression s'étend entre 10% et 25% de la largeur totale de la zone d'impression de la tête d'impression.

6. Procédé selon la revendication 4 ou la revendication 5, **caractérisé en ce que** la tête d'impression usagée comprend deux bords latéraux et une zone centrale, ladite tête d'impression usagée étant configurée de telle sorte que dans chacun des deux bords latéraux de la tête d'impression usagée, entre 30% et 60% des buses d'impression sont désactivées.

7. Procédé selon la revendication 6, **caractérisé en ce que** dans chacun des deux bords latéraux de la tête d'impression usagée, 50% des buses d'impression sont désactivées.

8. Procédé selon la revendication 7, **caractérisé en ce que** dans chacun des deux bords latéraux de la tête d'impression usagée, les buses d'impression sont désactivées de manière alternée.

9. Procédé selon l'une quelconque des revendications 1 à 8, **caractérisé en ce que** la couche supraconductrice (3) comprend une surface externe (5) de la couche supraconductrice et une surface interne (4) de la couche supraconductrice, dans lequel ladite surface interne (4) est en contact avec le substrat (2) et dans lequel entre 30-90% de la largeur de ladite surface externe (5) est en contact avec la couche de déviation du flux de courant (6) et entre 10-70% de la largeur de ladite surface externe (5) est en contact avec la surface interne (11) de la couche stabilisatrice.

10. Procédé selon la revendication 9, **caractérisé en ce que** la couche de déviation du flux de courant est imprimée par jet d'encre dans une voie centrale de la couche supraconductrice et dans lequel entre 80-90% de la largeur de la surface extérieure de la couche supraconductrice est en contact avec la couche de déviation du flux de courant et entre 10-20% de la largeur de la surface extérieure de la couche supraconductrice est en contact avec la surface intérieure de la couche stabilisatrice.

11. Procédé selon l'une quelconque des revendications 1 à 10, **caractérisé en ce que** la tête d'impression est une tête d'impression piézoélectrique.

12. Procédé selon l'une quelconque des revendications 1 à 11, **caractérisé en ce que,** après le dépôt de la couche de stabilisant, on effectue une étape d'oxygénation dans laquelle le matériau supraconducteur est traité thermiquement avec une courbe de température qui va d'une température comprise entre 650°C-550°C à une température comprise entre 500°C-400°C en diminuant de 1°C à 5°C toutes les 1 min à 5 min puis en maintenant la température finale au moins 8 heures, tout en étant exposé à un flux d'oxygène turbulent.

13. Procédé selon la revendication 12, **caractérisé en ce que** dans l'étape d'oxygénation, le matériau supraconducteur est traité thermiquement avec une courbe de température qui va d'une température comprise entre 600°C à une température de 450°C en réduisant de 2°C/min et en maintenant ensuite une température de 450°C pendant 8 heures, tout en étant exposé à un flux d'oxygène de 0,2 l/min à 1 l/min.

14. Procédé selon l'une quelconque des revendications 1 à 13, **caractérisé en ce que** la couche de stabilisant est une couche d'argent.

15. Procédé selon l'une quelconque des revendications 1 à 14, **caractérisé en ce que** le procédé comprend les étapes suivantes :
a) fournir une bande (12) comprenant un substrat (2) et une couche supraconductrice (3) déposée sur celui-ci, dans laquelle la couche supraconductrice comprend une surface interne (4) de la couche supraconductrice et une surface externe (5) de la couche supraconductrice et dans laquelle ladite surface interne est en contact avec le substrat ;
b) impression par jet d'encre de l'encre de déviation du flux de courant sur une partie de la surface extérieure de la couche supraconductrice lorsque la couche de déviation du flux de courant doit être située entre la couche supraconductrice et la couche stabilisatrice pour générer la couche de déviation du flux de courant (6);
c) durcissement aux UV de la couche de déviation du flux de courant du matériau supraconducteur obtenu à l'étape b) ;
d) séchage de la couche de déviation du flux de courant du matériau supraconducteur obtenu à l'étape c) ;
e) traitement thermique de la couche de déviation du flux de courant du matériau supraconducteur obtenu à l'étape d) ;
f) déposer la couche de stabilisateur sur la couche de déviation du flux de courant et la partie restante de la surface extérieure de la couche supraconductrice ;
g) oxygéner le matériau supraconducteur obtenu à l'étape f) ;
h) recueillir le matériau supraconducteur obtenu à l'étape g),
**caractérisé en ce que,** dans l'étape d'impression par jet d'encre, la couche de déviation du flux de courant est générée en réduisant la densité des gouttelettes de l'encre de déviation du flux de courant dans au moins un bord de la couche de déviation du flux de courant par rapport à la densité des gouttelettes de la région centrale de la couche de déviation du flux de courant.
